# EUROPEAN PATENT SPECIFICATION

(11) **EP 2 278 705 B1**
(45) Date of publication and mention of the grant of the patent: **10.08.2011**
(21) Application number: 09164243.9
(22) Date of filing: 30.06.2009
(51) Int. Cl.: H03F 1/02, H03F 1/56

(54) **Envelope tracking radio frequency power amplifier**
Hochfrequenz-Leistungsverstärker mit Hüllkurvennachführung
Amplificateur d'alimentation de fréquence radio à suivi d'enveloppe

(43) Date of publication of application: 26.01.2011
(73) Proprietor: Alcatel Lucent, 75008 Paris (FR)
(72) Inventor: Wiegner, Dirk, 71409 Schwaikheim (DE); Jueschke, Patrick, 75428 Illingen (DE)
(74) Representative: Schmidt, Werner Karl

(56) References cited:
- EP-A1- 1 885 058
- US-A- 5 339 041
- US-A1- 2004 075 494
- US-A1- 2006 145 758
- US-B1- 6 438 360

## Description

The present invention relates to an envelope tracking radio frequency power amplifier comprising a power transistor, which power transistor is an electrical intermediate between an input circuit with an input port and an output circuit with an output port of the power amplifier.

Conventional class-AB based radio frequency (RF) power amplifiers with fixed supply voltage are well known amplifiers matching for single standard applications. These class-AB based power amplifiers only achieve moderate efficiency for fixed supply voltage, with clear efficiency decrease for increased back-off operation, like e.g. in multistandard operation when peak-to-average signal increases.

To overcome these efficiency deficit, the Envelope Tracking (ET) concept and the resulting envelope tracking radio frequency power amplifier is known for efficiency enhancement. These envelope tracking RF power amplifiers comprise power transistors being electrical intermediates between an input circuit with an input port and an output circuit with an output port of the amplifier. In envelope tracking systems the supply voltage of the RF power amplifier is adapted to the instantaneous output power of the RF power amplifier. For low output power the supply voltage is reduced and for high output powers it is increased by a supply voltage modulator. In the ideal case the power amplifier is always driven near its maximum output power where it has maximum efficiency.

The key component of envelope tracking is the supply voltage modulator, which has to be very efficient. The supply voltage modulator is a power amplifier like the RF amplifier, but in contrast to the RF amplifier it has to amplify a lowpass signal.

Such envelope tracking RF power amplifiers are widely employed in the telecommunication applications, such as UMTS (UMTS: Universal Mobile Telecommunications System) or GSM (Global System for Mobile communications). The power amplifier typically comprises an amplifier transistor stage with a power transistor and a supply voltage modulator (envelope tracking modulator) generating a supply voltage according to a signal envelope of the signal at the input port.

Due to the fact, that the output matching has to be designed for one selected standard and signal with a specific peak-to-average ratio, this solution also shows certain efficiency degradation when applying different standards with different signal peak-to-average ratios, since the output matching is not necessarily optimal matched for these conditions any more.

Document US 5,339,041 A describes an envelope tracking radio frequency (RF) power amplifier including an envelope detector, efficient power supply and switch mode signal source, wherein the switch mode signal source is a class E amplifier, which amplifier invariably comprising a transistor connected between the input and the output of the amplifier. An output network of the amplifier comprises different output paths, wherein the active output path is selectable by a microprocessor by means of a pin diode driver.

It is the object of the invention to provide an envelope tracking radio frequency power amplifier which overcomes the aforementioned disadvantages.

This object is achieved by the present invention as defined in claim 1. The output circuit of the envelope tracking (ET) radio frequency (RF) power amplifier comprises a plurality of electrical output paths connected in parallel, each of said output paths connecting an output of the power transistor with the output port, wherein the output paths share at least one common section and each of the output paths is an individual matching path for impedance matching of the impedance at the output of the power transistor to the output impedance at the output port. In general, the output impedance is adapted to the input impedance of a load electrically connected to said output port. The advantage for multistandard application is to match different signal characteristics by the amplifier design, which means that different signals have e.g. different peak-to-average ratios which are considered by the different output paths of the matching output circuit. This results in different average voltage levels of the envelope tracked RF power amplifier. The output matching of each of the different output paths is designed for one selected standard corresponding to a signal with a specific peak-to-average ratio.

Each of the output paths comprises a λ/4-filter assembly with an individual characteristic frequency f1, f2 corresponding to appropriate used wavelength λ₁, λ₂. In a multiband implementation the characteristic frequencies f1, f2 differ from each other. Especially the output circuit consists of two output paths. The first output path is a matching path for signals with a frequency in a first band having a first centre frequency being the first characteristic frequency f1 and blocks the second characteristic frequency f2 outside the first band by the use of the λ/4-filter assembly with an individual characteristic frequency f2, wherein the corresponding wavelength λ₂ corresponds to said frequency f2. The second output path is a matching path for signals with a frequency in a second band having a second centre frequency being the second characteristic frequency f2 and blocks signals of the first characteristic frequency f1, which are outside the second band by the use of a λ/4-filter assembly with an individual characteristic frequency f1. The corresponding wavelength λ₁ corresponds to said frequency f1.

In case of multiband application, the matching is also frequency dependent which requires a matching for different frequency ranges. This concept covers a standard optimized matching for ET RF power amplifier in combination with multiband requirements to improve power and efficiency of the ET RF power amplifier.

Preferably the RF-range is a frequency range in the ultra high frequency (UHF) range with frequencies f1, ..., fn, each in a range from 300 to 3000 MHz (corresponding wavelengths λ₁, ... , λn, , each in a range from 10 - 100 cm) or super high frequency (SHF) range from 3 to 30 GHz (corresponding wavelength: 1-10 cm).

According to a preferred embodiment of the invention, the output paths at least share two common end sections, with the first common end section connecting the output of the transistor and the second common end section connecting the output port, wherein each of the output paths comprises an individual mid section between the first and second end section.

Generally the output paths can be any kind of lines. Preferably, the output paths are formed as microstrips. The microstrip is a type of electrical transmission line which can be fabricated using printed circuit board-(PCB)-technology, and is used to convey radio frequency signals. In general it consists of a conducting strip separated from a ground plane by a dielectric layer known as the substrate.

According to another preferred embodiment of the invention, at least one of the mid sections of the output paths comprises at least one adjustment stage. The adjustment stage of an output path is a sudden change in the size of the cross-sectional area of the path. The adjustment stage of an output path formed as a microstrip is a sudden change in the width of the microstrip section. The width of the microstrip or microstrip section is inversely proportional to the impedance magnitude it is adapted to.

In a multistandard implementation the characteristic frequencies preferably are identical.

The different output paths adapt the output matching specifically to the particularly different addressed communication standards and related signal peak-to-average ratios, as well as different frequency ranges for multiband applications. This is realized by adding specific matching paths to the output matching circuit of the envelope tracked (ET) power amplifier.

To select a path, the other path(s) is/are switched off by a λ/4 transformation to ground by means of the λ/4-filter assembly. The concept is scalable from two output paths to n output paths. For switching off the appropriate non-selected output path, each of the λ/4-filter assemblies of the output paths comprises at least one switching element. The switching element preferably is a PiN diode and/or a MEMS switch.

When designing the envelope tracked (ET) power amplifier, the multiband and multistandard aspects have to be taken into account. Therefore different output paths with shared common sections, especially the transistor pad as a first common end section of the output paths, give the opportunity to design a load network for different frequencies f1, ..., fn or different signal characteristics and even both (e.g. GSM together with UMTS, which means different frequency ranges (multiband) and different standards (multistandard).

According to another embodiment of the invention, the input circuit is an input circuit for matching the impedance at the input port to the impedance at an input of the power transistor.

According to one embodiment of the invention, the input circuit comprises a single input path interconnecting the input port and the input of the power transistor. Alternatively, the input circuit comprises a plurality of electrical input paths connected in parallel, each of said input paths connecting the input port with the input of the power transistor. Preferably, each of the input paths is an individual matching path for impedance matching related to the respective output path.

Generally the input path(s) can be any kind of line(s). Especially, the input path is formed as a microstrip or the input paths are formed as microstrips.

According to another preferred embodiment of the invention, the input circuit is an input circuit for matching the impedance at the input port to the impedance at an input of the power transistor.

According to yet another preferred embodiment of the invention, the input paths share at least one common section. Especially, the common sections of the input paths are end sections of the input paths.

According to another preferred embodiment of the invention, each of the input paths comprises λ/4-filter assembly with the individual characteristic frequency of the respective output path. Preferably at least one of the λ/4-filter assemblies of the input paths comprises a switching element for switching off the appropriate non-selected output path. Preferably the switching element is a PiN diode and/or MEMS switch.

These and other aspects of the invention will be apparent from and elucidated with reference to the embodiments described hereinafter.

In the drawings:
Fig. 1 shows an envelope tracking radio frequency power amplifier according to a first embodiment of the invention;
Fig. 2 shows an envelope tracking radio frequency power amplifier according to a second embodiment of the invention; and
Fig. 3 shows an envelope tracking radio frequency power amplifier according to a third embodiment of the invention.

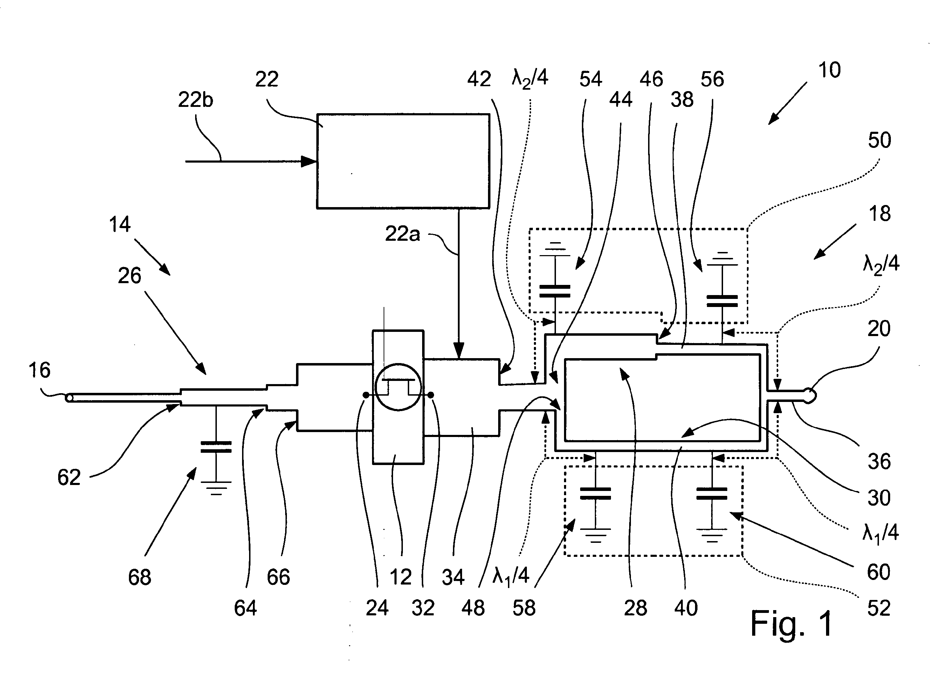

Fig. 1 depicts an envelope tracking radio frequency power amplifier 10 (ET RF power amplifier 10) comprising a transistor stage with a power transistor 12 (as indicated by the graphic symbol), which power transistor 12 is an electrical intermediate between an input circuit 14 with an input port 16 and an output circuit 18 with an output port 20 of the power amplifier 10. The power amplifier 10 further comprises an envelope tracking circuit comprising a supply voltage modulator 22 modulating the supply voltage (arrow 22a) of the power transistor 12 depending on a signal envelope (arrow 22b) of an input signal.

The input circuit 14 is an input circuit for matching the impedance at the input port 16 (e.g. 50 Ω) to the impedance at an input 24 (e. g. 2 Ω) of the power transistor 12. The input circuit 14 comprises only one input path 26, which is an input path 26 for matching the impedance at the input port 16 to the input 24 of the power transistor 12.

The output circuit 18 comprises two electrical output paths 28, 30 connected in parallel, each of said output paths 28, 30 connects an output 32 of the power transistor 12 with the output port 20 of the ET RF power amplifier 10, wherein each of the output paths 28, 30 is an individual matching path 28, 30 for impedance matching of the impedance at the output 32 of the power transistor 12 to the impedance at the output port 20. The output paths 28, 30 share two common end sections 34, 36, with the first common end section 34 connecting the output 32 of the transistor 12 and the second common end section 36 connecting the output port 20. Each of the output paths 28, 30 comprises an individual mid sections 38, 40 arranged between the common end sections 34, 36. The first common output section 34 shared by the output paths 28, 30 is a transistor output pad. The input path 26 of the input circuit 14 and the output paths 28, 30 of the output circuit 18 are realized by the use of microstrips (microstrip-lines).

The first output path 28 being a first matching path comprises three impedance adjustment stages 42, 44, 46 for enhancing the impedance from e.g. 1.5 Ω at the output 32 of the transistor 12 to 50 Ω (output impedance of the ET RF power amplifier) at the output port 20. The second output path 30 being a second matching path comprises only two impedance adjustment stages 42, 48 for enhancing the impedance from 1.5 Ω at the output 32 of the transistor 12 to 50 Ω at the output port 20. The different impedance adjustment structures of each of the matching paths (output paths 28, 30) are optimized for a peak-to-average signal of a corresponding signal standard (e.g. UMTS and GSM) and/or for a corresponding frequency f1, f2.

Each of the output paths 28, 30 further comprises a λ/4-filter assembly 50, 52 with an individual characteristic (centre) frequency f1, f2, wherein a first wavelength λ₁ corresponds to the first frequency f1 and a second wavelength λ₂ corresponds to the second frequency f2. Each of the λ/4-filter assemblies 50, 52 comprises two capacitive RF blocks 54, 56; 58, 60 connected between the output path 28, 30 and a reference potential (ground potential). Each block 54, 56; 58, 60 is located at a distance of λ₁/4 or λ₂/4 respectively from a corresponding splitting points between a common end section 34, 36 and the mid section 38, 40.

To optimize the performance of the envelope trace RF power amplifier 10, the required output path 28, 30 is selected by switching off the unused path28,30 by a λ/4 transformation to ground.

The different matching output paths 28, 30 to the output port 20 of the RF power amplifier 10 are in order to improve/optimize the output matching of the power amplifier 10 and thus efficiency related to frequency, signal and communication standard. The frequencies f1, f2 can be different (multiband) or even the same (multistandard). The concept is scalable to n ways of matching, covering different frequencies and signal requirements.

The input path 26 shown in Fig. 1 is a matching path as well and comprises three impedance adjustment stages 62, 64, 66 connecting four microstrip lines with different width of a serial connection. Generally, the number n of stages is adapted to the application. A further capacitive RF block 68 is connected between the input path 26 and a reference potential (ground potential.

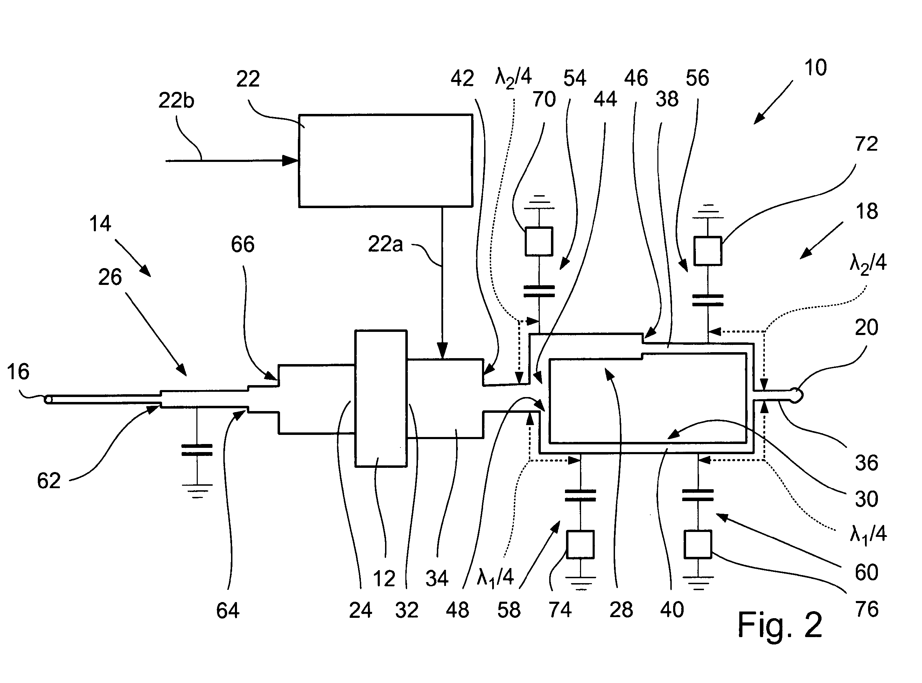

Fig. 2 shows an envelope tracking radio frequency power amplifier 10 according to a second embodiment of the invention. The envelope tracking radio frequency power amplifier 10 of Fig. 2 is substantially arranged in accordance with the arrangement of the envelope tracking radio frequency power amplifier 10 shown in Fig. 1. Solely each of the capacitive RF blocks 54, 56; 58, 60 comprises a switching element 70, 72, 74, 76 arranged between the capacitor and the reference potential for switching of the unused output path 28, 30 by the λ/4 transformation. Each of the switching elements 70, 72, 74, 76 preferably is a PiN diode or a MEMS switch. A PiN diode is a diode with a wide, lightly doped 'near' intrinsic semiconductor region between a p-type semiconductor and n-type semiconductor regions. The PiN diode operates under what is known as high-level injection.

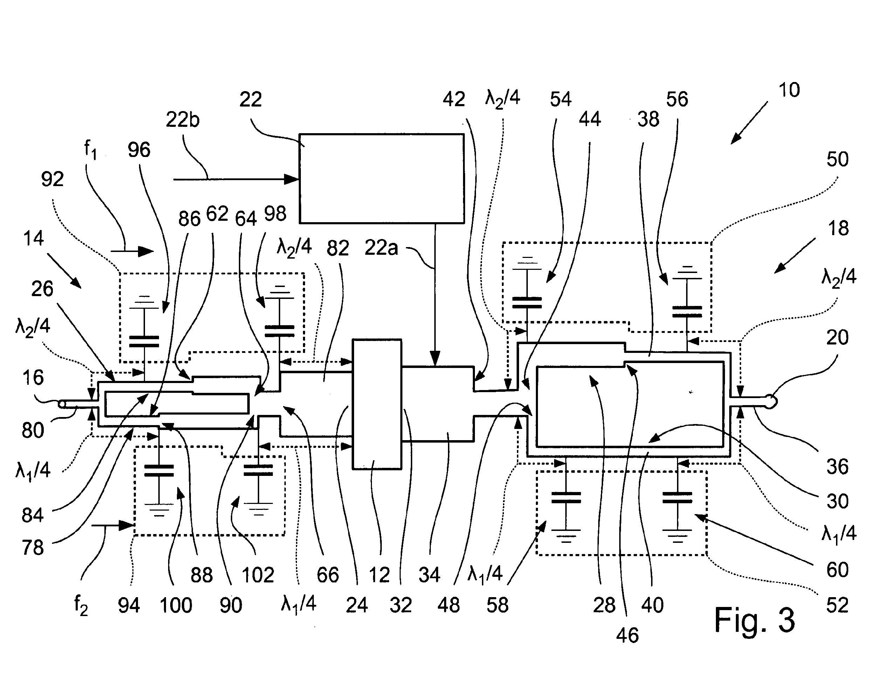

The envelope tracking radio frequency power amplifier 10 of Fig. 3 is substantially arranged in accordance with the arrangement of the envelope tracking radio frequency power amplifier 10 shown in Fig. 1.

The input circuit 14 comprises two electrical input paths 26, 78 connected in parallel, each of said input paths 26, 78 connecting the input port 16 of the ET RF power amplifier 10 with the input 24 of the power transistor 12, wherein each of the input paths 26, 78 is an individual matching path 26, 78 for impedance matching of the impedance at the impedance at the input port 16 to the input 24 of the power transistor 12. The input paths 26, 78 share two common end sections 80, 82, with the first common end section 80 connecting the input port 16 and the second common end section 82 connecting the input of the power transistor 12. Each of the input paths 26, 78 comprises an individual mid sections 84, 86 arranged between the common end sections 80, 82. The input paths 26, 78 and the output paths 28, 30 are microstrips (conductor paths). The second common output section 82 shared by the output paths 26, 78 is a transistor input pad.

The (first) input path 26 is a first matching path and comprises three impedance adjustment stages 62, 64, 66 for enhancing the impedance from e.g. 50 Ω at the input port 16 to 2 Ω at the input 24 of the transistor 12. The second input path 78 is a second matching path comprising three impedance adjustment stages 66, 88, 90 for enhancing the impedance from said 50 Ω at the input port 16 to 2 Ω at the input 24 of the transistor 12. The different impedance adjustment structures of each of the matching paths are optimized for a peak-to-average signal of a corresponding signal standard (e.g. UMTS and GSM) and/or for a corresponding frequency f1, f2.

This input optimization is not ET tuned and achieves a better performance of the whole amplifier for multiband applications.

Each of the input paths 26, 78 further comprises a λ/4-filter assembly 92, 94 with the individual characteristic (centre) frequency f1, f2. Each of the λ/4-filter assemblies 92, 94 comprises two capacitive RF blocks 54, 56; 58, 60 connected between the output path 28, 30 and a reference potential (ground potential). Each block 96, 98; 100, 102 is located at a distance of λ₁/4 or λ₂/4 respectively from a corresponding splitting points between a common end section 80, 82 and the mid section 84, 86.

Preferably, each of the capacitive RF blocks 96, 98; 100, 102 comprises a switching element (not shown) arranged between the capacitor and the reference potential for switching of the unused input path 26, 78 by the λ/4 transformation.

While the invention has been illustrated and described in detail in the drawings and foregoing description, such illustration and description are to be considered illustrative or exemplary and not restrictive; the invention is not limited to the disclosed embodiments.

Other variations to be disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

## Claims

1. An envelope tracking radio frequency power amplifier (10) comprising a power transistor (12), which power transistor (12) is an electrical intermediate between an input circuit (14) with an input port (16) and an output circuit (18) with an output port (20) of the power amplifier (10), wherein the output circuit (18) comprises a plurality of electrical output paths (28, 30) connected in parallel, each of said output paths (28, 30) connecting an output (32) of the power transistor (12) with the output port (20), wherein the output paths (28, 30) share at least one common section (34, 36) and each of the output paths (28, 30) is an individual matching path for impedance matching of the impedance at the output (32) of the power transistor (12) to the output impedance at the output port (20), **characterized in that** each of the output paths (28, 30) comprises a λ/4-filter assembly (50, 52) with an individual characteristic frequency (f1, f2).

2. The power amplifier according to claim 1, wherein the output paths (28, 30) at least share two common end sections (38, 40), with the first common end section (38) connecting the output of the transistor (32) and the second common end section (40) connecting the output port (20), wherein each of the output paths (28, 30) comprises an individual mid section (38, 40).

3. The power amplifier according to claim 1, wherein the output paths (28, 30) are formed as microstrips.

4. The power amplifier according to claim 2, wherein at least one of the mid sections (38, 40) of the output paths (28, 30) comprises at least one adjustment stage (42, 44, 46, 48).

5. The power amplifier according to claim 1, wherein the λ/4-filter assembly (50, 52) of the output paths (28, 30) comprises at least one switching element (70, 72, 74, 76).

6. The power amplifier according to claim 1, wherein the input circuit (14) is an input circuit for matching the impedance at the input port (16) to the impedance at an input (24) of the power transistor (12).

7. The power amplifier according to claim 1, wherein the input circuit (14) comprises a single input path (26) interconnecting the input port (16) and the input (24) of the power transistor (12).

8. The power amplifier according to claim 1, wherein the input circuit (14) comprises a plurality of electrical input paths (26, 78) connected in parallel, each of said input paths (26, 78) connecting the input port (16) with the input (24) of the power transistor (12).

9. The power amplifier according to claim 7 or 8, wherein the at least one input path (26, 78) is formed as a microstrip.

10. The power amplifier according to claim 8, wherein the input path (26, 78) share at least one common section (80, 82).

11. The power amplifier according to claim 8, wherein the common sections (80, 82) of the input paths (26, 78) are common end sections (80, 82) of the input paths (26, 78).

12. The power amplifier according to claim 8, wherein each of the input paths (26, 78) comprises a λ/4-filter assembly (92, 94) with the individual characteristic frequency (f1, f2) of the respective output path (28, 30).

13. The power amplifier according to claim 12, wherein at least one of the λ/4-filter assemblies (94, 96) of the at least one input paths (26, 78) comprises a switching element.

## Patentansprüche

1. Hochfrequenz-Leistungsverstärker mit Hüllkurvennachführung (10), umfassend einen Leistungstransistor (12), wobei der besagte Leistungstransistor (12) ein elektrisches Zwischenelement zwischen einer Eingangsschaltung (14) mit einem Eingangsport (16) und einer Ausgangsschaltung (18) mit einem Ausgangsport (20) des Leistungsverstärkers (10) ist, wobei die Ausgangsschaltung (18) eine Mehrzahl von parallel geschalteten elektrischen Ausgangspfaden (28, 30) umfasst, wobei ein jeder der besagten Ausgangspfade (28, 30) einen Ausgang (32) des Leistungstransistors (12) mit dem Ausgangsport (20) verbindet, wobei sich die Ausgangspfade (28, 30) mindestens einen gemeinsamen Abschnitt (34, 36) teilen und ein jeder der Ausgangspfade (28, 30) ein individueller Anpassungspfad zur Anpassung der Impedanz am Ausgang (32) des Leistungstransistors (12) an die Ausgangsimpedanz am Ausgangsport (20) ist, **dadurch gekennzeichnet, dass** ein jeder der Ausgangspfade (28, 30) eine λ/4-Filteranordnung (50, 52) mit einer individuellen charakteristischen Frequenz (f1, f2) umfasst.

2. Der Leistungsverstärker nach Anspruch 1, wobei sich die Ausgangspfade (28, 30) mindestens zwei gemeinsame Endabschnitte (38, 40) teilen, wobei der erste gemeinsame Endabschnitt (38) den Ausgang des Transistors (32) verbindet und der zweite gemeinsame Endabschnitt (40) den Ausgangsport (20) verbindet, wobei ein jeder der Ausgangspfade (28, 30) einen individuellen mittleren Abschnitt (38, 40) umfasst.

3. Der Leistungsverstärker nach Anspruch 1, wobei die Ausgangspfade (28, 30) als Mikrostreifen ausgebildet sind.

4. Der Leistungsverstärker nach Anspruch 2, wobei zumindest einer der mittleren Abschnitte (38, 40) der Ausgangspfade (28, 30) mindestens eine Einstellungsstufe (42, 44, 46, 48) umfasst.

5. Der Leistungsverstärker nach Anspruch 1, wobei die λ/4-Filteranordnung (50, 52) der Ausgangspfade (28, 30) mindestens ein Schaltelement (70, 72, 74, 76) umfasst.

6. Der Leistungsverstärker nach Anspruch 1, wobei die Eingangsschaltung (14) eine Eingangsschaltung zur Anpassung der Impedanz am Eingangsport (16) an die Impedanz an einem Eingang (24) des Leistungstransistors (12) ist.

7. Der Leistungsverstärker nach Anspruch 1, wobei die Eingangsschaltung (14) einen einzelnen Eingangspfad (26) umfasst, welcher den Eingangsport (16) und den Eingang (24) des Leistungstransistors (12) miteinander verbindet.

8. Der Leistungsverstärker nach Anspruch 1, wobei die Eingangsschaltung (14) eine Mehrzahl von parallel geschalteten elektrischen Eingangspfaden (26, 78) umfasst, wobei ein jeder der besagten Eingangspfade (26, 78) den Eingangsport (16) mit dem Eingang (24) des Leistungstransistors (12) verbindet.

9. Der Leistungsverstärker nach Anspruch 7 oder 8, wobei der mindestens eine Eingangspfad (26, 78) als ein Mikrostreifen ausgebildet ist.

10. Der Leistungsverstärker nach Anspruch 8, wobei sich die Eingangspfade (26, 78) mindestens einen gemeinsamen Abschnitt (80, 82) teilen.

11. Der Leistungsverstärker nach Anspruch 8, wobei die gemeinsamen Endabschnitte (80, 82) der Eingangspfade (26, 78) gemeinsame Endabschnitte (80, 82) der Eingangspfade (26, 78) sind.

12. Der Leistungsverstärker nach Anspruch 8, wobei ein jeder der Eingangspfade (26, 78) eine λ/4-Filteranordnung (92, 94) mit der individuellen charakteristischen Frequenz (f1, f2) des jeweiligen Ausgangspfads (28, 30) umfasst.

13. Der Leistungsverstärker nach Anspruch 12, wobei mindestens eine der λ/4-Filteranordnungen (94, 96) des mindestens einen Eingangspfads (26, 78) ein Schaltelement umfasst.

## Revendications

1. Amplificateur de puissance radioélectrique à suivi d'enveloppe (10) comprenant un transistor de puissance (12), ledit transistor de puissance (12) étant un intermédiaire électrique entre un circuit d'entrée (14) doté d'un port d'entrée (16) et un circuit de sortie (18) doté d'un port de sortie (20) de l'amplificateur de puissance (10), dans lequel le circuit de sortie (18) comprend une pluralité de trajets électriques de sortie (28, 30) connectés en parallèle, chacun desdits trajets de sortie (28, 30) reliant une sortie (32) du transistor de puissance (12) au port de sortie (20), dans lequel les trajets de sortie (28, 30) partagent au moins une section commune (34, 36) et chacun des trajets de sortie (28, 30) est un trajet individuel de mise en correspondance pour la mise en correspondance de l'impédance à la sortie (32) du transistor de puissance (12) avec l'impédance de sortie au port de sortie (20), **caractérisé en ce que** chacun des trajets de sortie (28, 30) comprend un ensemble filtre λ/4 (50, 52) avec une fréquence caractéristique individuelle (f1, f2).

2. Amplificateur de puissance selon la revendication 1, dans lequel les trajets de sortie (28, 30) partagent au moins deux sections d'extrémité (38, 40), la première section d'extrémité commune (38) reliant la sortie du transistor (32) et la deuxième section d'extrémité commune (40) reliant le port de sortie (20), dans lequel chacun des trajets de sortie (28, 30) comprend une section médiane individuelle (38, 40).

3. Amplificateur de puissance selon la revendication 1, dans lequel les trajets de sortie (28. 30) sont formés comme des lignes microrubans.

4. Amplificateur de puissance selon la revendication 2, dans lequel au moins une des sections médianes (38, 40) des trajets de sortie (28, 30) comprend au moins un étage de réglage (42, 44, 46, 48).

5. Amplificateur de puissance selon la revendication 1, dans lequel l'ensemble filtre λ/4 (50, 52) des trajets de sortie (28, 30) comprend au moins un élément de commutation (70, 72, 74, 76).

6. Amplificateur de puissance selon la revendication 1, dans lequel le circuit d'entrée (14) est un circuit d'entrée pour mettre en correspondance l'impédance au niveau du port d'entrée (16) avec l'impédance à une entrée (24) du transistor de puissance (12).

7. Amplificateur de puissance selon la revendication 1, dans lequel le circuit d'entrée (14) comprend un trajet d'entrée unique (26) interconnectant le port d'entrée (16) et l'entrée (24) du transistor de puissance (12).

8. Amplificateur de puissance selon la revendication 1, dans lequel le circuit d'entrée (14) comprend une pluralité de trajets d'entrée électriques (26, 78) connectés en parallèle, chacun desdits trajets d'entrée (26, 78) reliant le port d'entrée (16) à l'entrée (24) du transistor de puissance (12).

9. Amplificateur de puissance selon la revendication 7 ou 8, dans lequel l'au moins un trajet d'entrée (26, 78) est formé comme une ligne microruban.

10. Amplificateur de puissance selon la revendication 8, dans lequel le trajet d'entrée (26, 78) partage au moins une section commune (80, 82).

11. Amplificateur de puissance selon la revendication 8, dans lequel les sections communes (80, 82) des trajets d'entrée (26, 78) sont des sections d'extrémité communes (80, 82) des trajets d'entrée (26, 78).

12. Amplificateur de puissance selon la revendication 8, dans lequel chacun des trajets d'entrée (26, 78) comprend un ensemble filtre λ/4 (92, 94) avec la fréquence caractéristique individuelle (f1, f2) du trajet de sortie respectif (28, 30).

13. Amplificateur de puissance selon la revendication 12, dans lequel au moins un des ensembles filtres λ/4 (94, 96) de l'au moins un trajet d'entrée (26, 78) comprend un élément de commutation.
